# EUROPEAN PATENT SPECIFICATION

(11) **EP 0 556 639 B1**
(45) Date of publication and mention of the grant of the patent: **12.07.1995**
(21) Application number: 93101640.6
(22) Date of filing: 03.02.1993
(51) Int. Cl.: H01S 3/025, G02B 6/42, H01L 31/105

(54) **Semiconductor laser device**
Halbleiterlaservorrichtung
Dispositif laser à semi-conducteur

(30) Priority: 03.02.1992 JP 17625/92
(43) Date of publication of application: 25.08.1993
(73) Proprietor: SUMITOMO ELECTRIC INDUSTRIES, LIMITED, Osaka 541 (JP)
(72) Inventor: Kuhara, Yoshiki, c/o Osaka Works of, Konohana-ku, Osaka (JP); Nakanishi, Hiromi, c/o Osaka Works of, Konohana-ku, Osaka (JP); Tonai, Ichiro, c/o Osaka Works of, Konohana-ku, Osaka (JP); Murakami, Kazuhito, c/o Osaka Works of, Konohana-ku, Osaka (JP)
(74) Representative: Kahler, Kurt, Dipl.-Ing.

(56) References cited:
- EP-A- 0 436 380
- EP-A- 0 473 198
- PATENT ABSTRACTS OF JAPAN vol. 15, no. 078 (E-1037)22 February 1991 & JP-A-02 297 988 (MITSUBISHI ELECTRIC CORP)
- IEE PROCEEDINGS J. OPTOELECTRONICS vol. 137, no. 3, June 1990, STEVENAGE GB pages 171 - 173, C.S. Yin et al.: 'High quantum efficiency p+/pi/n-/n+ silicon photodiode'
- PATENT ABSTRACTS OF JAPAN vol. 14, no. 239 (E-930)21 May 1990 & JP-A-02 065 279 (NEC CORP)
- PATENT ABSTRACTS OF JAPAN vol. 15, no. 196 (P-1203)21 May 1991 & JP-A-03 048 209 (HITACHI LTD)
- PATENT ABSTRACTS OF JAPAN vol. 10, no. 35 (E-380)12 February 1986 & JP-A-60 192 382 (NIPPON DENKI KK)
- PATENT ABSTRACTS OF JAPAN vol. 14, no. 380 (E-965)25 May 1990 & JP-A-02 137 389 (NEC CORP)

## Description

This invention relates to a semiconductor laser device used in transmission devices, etc. of the optical communication systems.

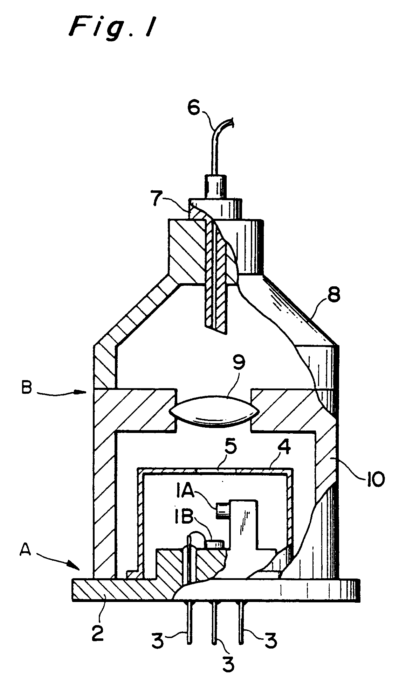

The semiconductor laser device used in the optical communication using optical fibers is exemplified by the one as shown in Fig. 1 (a first prior art) which comprises a semiconductor laser chip 1A as a signal light source and a photodiode chip 1B as light detecting means for monitoring the light emitted from the rear end surface (lower end surface as viewed in Fig. 1) of the semiconductor laser chip 1A which is mounted on a header 2, and lead wires 3 connecting the photodiode chip 1B to a monitor circuit and connecting the semiconductor laser chip to an outside drive circuit (not shown).

In Fig. 1, a cap 4 has a light transmitting window 5 which passes the signal light emitted from the semiconductor laser chip 1A and airtightly seals the semiconductor laser chip 1A and the photodiode chip 1B.

A condenser lens 9 secured to a lens holder 10 is used to cause the signal light emitted from the semiconductor laser chip 1A to effectively enter an optical fiber 6 inserted in a housing 8 through a ferrule 7. Especially the structure of Fig. 1 is called coaxial type.

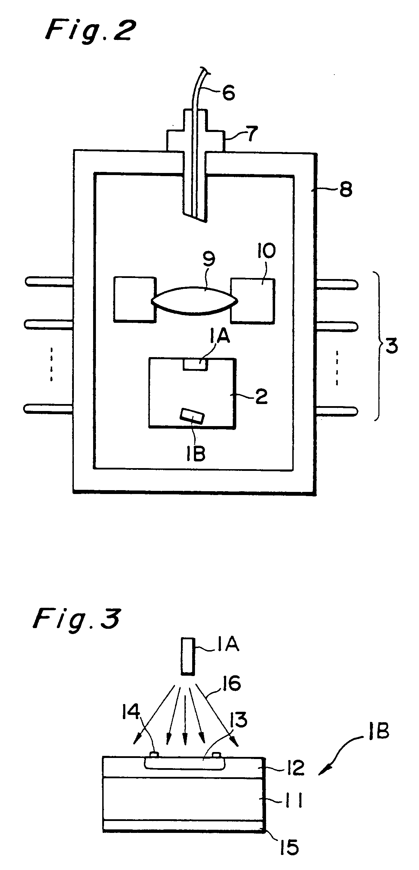

On the other hand, the semiconductor laser device (a second prior art) shown in Fig. 2 is called butterfly type and has a housing 8 of rectangular section. This semiconductor laser device has basically the same function as the first prior art. But it is possible that an IC (integrated circuit) chip for the laser drive circuit and the monitor circuit is mounted on the header 2 secured in the housing 8.

The photodiode chip 1B as the light detecting means comprises, as shown in Fig. 3, an epitaxial layer 12 grown on a semiconductor substrate 11, and a diffusion region 13 formed on the surface of the epitaxial layer 12 by thermal diffusion of a metal element and having an opposite polarity to that of the epitaxial layer 12.

The interface between the epitaxial layer 12 and the diffusion region 13 have a p-n junction, so that the light radiated to the p-n junction contributes to the generation of a photocurrent. The generated photocurrent is taken outside for monitoring through electrodes 14, 15.

But these conventional semiconductor laser devices have the following problems.

The above-described semiconductor laser devices have properties that the semiconductor laser chip 1A as the signal light source tends to have unstable emitted light intensities corresponding to temperature changes. The signal light emitted from the semiconductor laser chip 1A is monitored by the photodiode chip 1B to control an average current to be applied to the semiconductor laser chip 1A to be constant so that a level of the light monitored by the outside electronic circuit is maintained constant.

But to operate the semiconductor laser chip 1A more stably at a high speed above about 100 Mbps, the control of the average current is not sufficient. Actually, it is also necessary to detect a minimum emitted light intensity and a maximum one and control a level of the emitted light intensity. But the conventional semiconductor laser devices, which use the photodiode chip 1B of the above-described common structure, cannot accurately detect a minimum and a maximum emitted light intensity, and it is difficult to put the conventional semiconductor laser devices to practical uses.

This is because a photocurrent generated by the light radiated to a part of the surface of the photodiode apart from the light detecting region (p-n junction) becomes a slow response component which does not follow a change of an emitted light intensity of a laser beam.

In Fig. 3 reference numeral 16 indicates a divergence of a light beam emitted from the semiconductor laser chip 1A. Carriers generated by those of the beams absorbed in the light detecting region 13 (a light detecting window) on the surface of the photodiode chip 1B and its very neighboring area (e. g., 3 - 5 »m) are effectively isolated at high speed by an electric field applied to the p-n junction and contribute to the generation of a photocurrent. But the signal light absorbed outside the region and the area adversely generates a very slow response photocurrent because the electric field is not applied thereto.

Consequently, in monitoring digital signal light, signal waveform distortions occur (especially a rectangular pulse trails by »sec at the fall), and maximum and minimum values cannot be accurately detected. High-speed, stable modulation cannot be performed.

In the conventional semiconductor laser devices, because of this problem, a position of the photodiode chip 1B on the header is finely adjusted so that the signal light emitted from the rear end surface (the lower end surface in Fig. 1) is incident only on the light detecting region of the photodiode chip 1B. A resultant problem is that it takes more time to mount a photodiode chip 1B on the header 2 because the mounting position of the photodiode chip 1B on the header 2 has to be finely adjusted. This problem is a neck to the massproduction.

Although the semiconductor laser device is essential to the optical communication, the device has such problems and cannot be put to all uses, which is a neck to the rapid prevalence of the optical communication systems.

This invention has been made to solve the above-described problems, and an object of this invention is to provide a semiconductor laser device having a structure which is easy to be fabricated.

This invention as defined in claim 1 relates to a semiconductor laser device in which a housing having an optical fiber inserted therein is integrally secured to a header having a semiconductor laser chip mounted thereon, the light emitting surface of the semiconductor laser chip and the end surface of the optical fiber are opposed to each other, and there is provided a photodiode chip for detecting the signal light emitted from the backside (rear end surface) of the light emitting surface of the semiconductor laser chip, the photodiode chip including on the light detecting surface opposed to the rear end surface of the semiconductor laser chip a p-n junction for outputting a photocurrent in a detected signal and a region for capturing carriers generated in a peripheral area of the p-n junction.

Especially the photodiode chip is characterized in that a p-n junction as the light detecting region is formed by thermal diffusion of a metal element on an epitaxial layer grown on a substrate (the light detecting region and the epitaxial layer have opposite polarities to each other), and a charge capturing region is formed around the p-n junction by the same method.

According to this invention, the photodiode chip is provided for monitoring an intensity of emitted light from the semiconductor laser chip as the signal light source and includes the charge capturing region for unnecessary carriers. Such photodiode chip can be easily mounted.

The photodiode chip mounted on the semiconductor laser device has the region for capturing unnecessary carriers generated by signal light radiated to an area outside the light detecting region. Even when the signal light from the rear end surface of the semiconductor laser chip is radiated to the peripheral area of the light detecting region, no slow response component is generated in the photocurrent signal.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only.

### Brief description of the drawings:

- Fig. 1: is a broken side view of a first example of the conventional semiconductor laser device.
- Fig. 2: is a sectional view of a second example of the conventional semiconductor laser device.
- Fig. 3: is a sectional view of a photodiode chip installed in the conventional semiconductor laser devices.
- Fig. 4A: is a broken side view of the semiconductor laser device according to a first embodiment of this invention.
- Fig. 4B: is a sectional view of major part of the semiconductor laser device according to the first embodiment of this invention.
- Fig. 5: is a sectional view of a charge capturing photodiode chip used in this invention.
- Fig. 6: is a broken side view of the semiconductor laser device according to second embodiment of this invention.

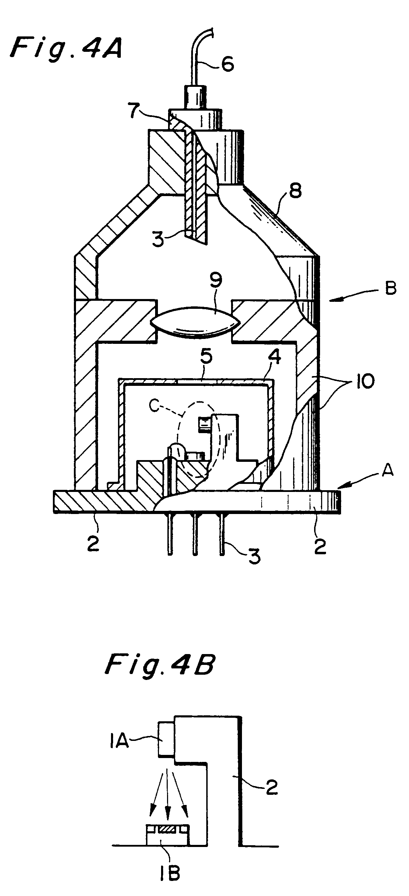

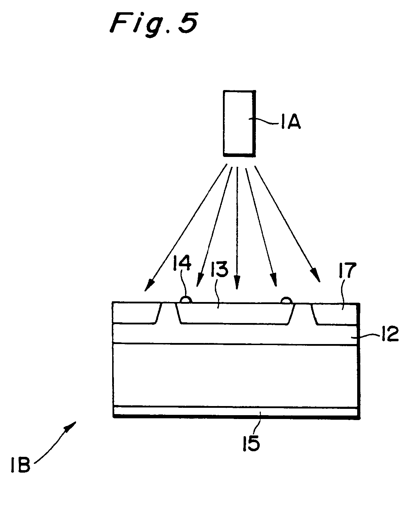

The semiconductor laser device according to a first embodiment of this invention will be explained with reference to Figs. 4 and 5.

Fig. 4A is a broken side view of a major part of the semiconductor laser device according to a first embodiment of this invention. Fig. 4B is an enlarged view of the part C in Fig. 4A (the upper part of a header 2).

A difference of the conventional semiconductor laser device (Fig. 1) is that the photodiode chip 1B for monitoring the signal light emitted from the rear end surface of the semiconductor laser chip 1A as enlarged in Fig. 4B, is provided by a semiconductor of the type (called charge capturing photodiode chip) in which a photocurrent generated by the signal light radiated to a peripheral area of the p-n junction as the light detecting region is made unreactive.

As shown in Fig. 4B, a semiconductor chip 1A is mounted on a header 2, and a semiconductor chip 1B is also mounted on the header 2 on the side of the rear end surface of the semiconductor chip 1A. A lens holder 10 and a housing 8 are integrated with the header 2.

An optical fiber 6 is inserted in the housing through a ferrule 7. The end surface of the optical fiber 5 is opposed to the light emitting surface of the semiconductor laser chip 1B across a lens 9 and a light transmitting window 5.

The photodiode chip 1B used in the semiconductor laser device according to this first embodiment of this invention can be provided by a charge capturing photodiode chip of the structure in which the photocurrent generated by the light radiated in a peripheral area of the p-n junction, i. e., the light detecting region, is made unreactive. One example of the structure is shown in Fig. 5.

A region 17 having the same polarity as a light detecting region 13 is formed on an epitaxial layer on a substrate by thermal diffusion of a metal element, whereby the photocarriers generated in the region 17 do not flow to the light detecting region 13 but extinguish near the p-n junction between the epitaxial layer 12 and the region 17, or the p-n junction exposed on the end surfaces of the chip. This is specifically described in EP-A-0 473 198 forming state of the art according to Article 54(3) EPC.

By using such improved photodiode chip 1B in monitoring an emitted light intensity, no slow response component of a photocurrent is generated even in a state where a monitored beam from the semiconductor laser chip 1A is divergent. The photodiode chip 1B can be easily mounted, and resultantly semiconductor laser devices can be easily fabricated and can be accordingly inexpensive.

The inventors have fabricated the semiconductor laser device having the structure of Fig. 4A.

A 1.3 »m-wavelength InGaAsP semiconductor laser chip 1A and the improved photodiode chip 1B of InGaAs are mounted on a header 2 of Fe for CD lasers. The photodiode chip 1B is electrically connected to a lead 3 with an Au wire.

The photodiode chip 1B is provided by a charge capturing type photodiode chip 1B comprising a p-n junction as a light detecting region 13 of 300 »m in diameter formed by thermal diffusion of Zn on an InGaAs epitaxial layer 12, and a charge capturing region 17 formed thereon by the same method. Needless to say, the p-n junction of this photodiode chip 1B is passivated with a SiN film, and the entire surfaces of the light detecting region 13 and of the charge capturing region 17 are covered with an antireflection film.

Then the semiconductor laser chip 1A and the photodiode chip 1B are airtightly sealed by a cap 4 having a light transmitting window 5, and the interior of the cap is filled with nitrogen gas. The condenser lens 9 is provided by a spherical lens. The spherical lens is secured to a stainless holder 10. And this lens is so set by monitoring from above with a TV monitor that the light emitting portion of the semiconductor laser chip 1A is seen at the center of the lens, and next is YAG welded to each other at the part A in Fig. 4A by YAG laser.

Then a housing 8 with an optical fiber 6 inserted through a ferrule 7, and the lens holder 10 are brought nearer to be welded to each other by YAG laser at the part B by monitoring intensities of the light incident on the end surface of the optical fiber 6 for a maximum light intensity.

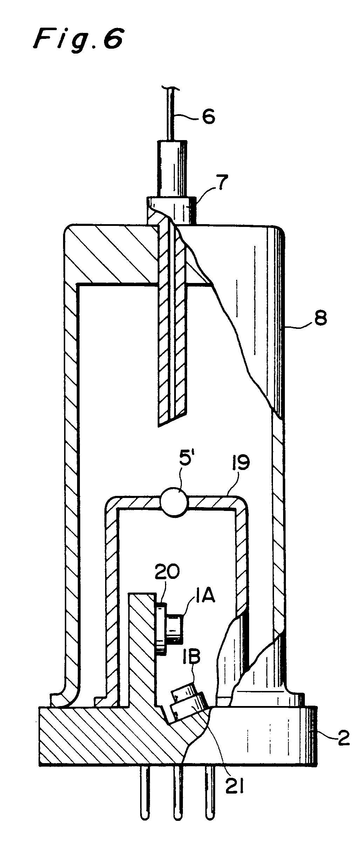

Next, the semiconductor laser device according to a second embodiment of this invention will be explained with reference to Fig. 6.

In this embodiment, a 1.55 »m-wavelength InGaAs semiconductor laser chip 1A is mounted on a Si submount 20 with an AuSn eutectic solder. In the case where the header 2 is provided by a metal package, the Si submount 20 secures the electric insulation between the semiconductor laser chip 1A and the metal package. The Si submount 20 as the header is mounted at a set position on the metal package by an SnPb solder. A photodiode chip 1B is mounted on a position on the header 2 (metal package) where the photodiode chip 1B can detect the light emitted from the rear end surface (lower end surface in Fig. 6) of the semiconductor laser chip 1A.

This photodiode chip 1B used in this embodiment has the same structure as that of the photodiode chip 1B used in the embodiment of Fig. 4A so that the charge generated by the light radiated to a peripheral area of the light detecting region is captured. Accordingly the positioning of the photodiode chip 1B can be less strict than that of the conventional photodiode chips. This contributes to raise a degree of design freedom of the metal package 2. This photodiode chip 1B is mounted on a submount 21 of alumina ceramics mounted on the metal package with an AuSn eutectic solder. The electrodes of the semiconductor laser chips 1A and of the photodiode chip 1B are electrically connected to a set of outside electrodes through Au wires.

A metal cap 19 with a spherical lens 5′ for coupling the signal light emitted from the forward end surface of the semiconductor laser chip 1A with the optical fiber 6 is, by projection welding, secured to the metal package 2 having the semiconductor laser chip 1A mounted thereon. Then a housing 8 with the optical fiber 6 inserted therein is secured to the metal package 2 similarly with projection welding. In securing the cap 19 and the housing 8, aligning means is used so that the light emitted from the semiconductor laser chip 1A is effectively incident on the optical fiber 6. The space airtightly closed by the metal package 2 and the cap 19 and accommodating the semiconductor laser chip 1A is filled with an inert gas, e. g., nitrogen gas, in its dry state, so that even in low temperature conditions the inert gas does not bedew the surfaces of the semiconductor devices. The materials of the semiconductors, the packages and the submounts are only examples, but other different materials can be selected depending on applications.

The improved semiconductor laser device using the thus-improved photodiode chip for monitoring can accurately monitor the state of an emitted laser beam, and resultantly can be stably driven up to high speeds and high temperatures. Furthermore, the positioning of the photodiode can be made less strictly, and resultantly the photodiode can be mounted easily. The charge capturing region having an antireflection film formed thereon can absorb unnecessary component of signal light, and resultantly no reflected light or scattered light, which makes the operation of the semiconductor laser unstable are generated, and resultantly the operation of the semiconductor laser device can be stable.

As described above, according to this invention, the photodiode chip as the monitoring light detecting means is provided by a photodiode chip having the structure provided with a region for capturing unnecessary carriers. Therefore, the photodiode chip can accurately detect waveforms of laser beams and stably operate even at high speed and at high temperature conditions. In addition, the positioning of the photodiode can be made less strictly, and resultantly the photodiode can be easily mounted. The charge capturing region with the antireflection film formed thereon can collect an unnecessary component of signal light, and resultantly reflection light and scattered light, which makes the operation of the semiconductor laser unstable with signal light, are not generated, and a stable operative semiconductor laser device can be provided.

The semiconductor laser device according to this invention is essential as a component to the machines and instruments especially provided for the high-speed data transfer and the optical communication subscribers among the communication networks in which the optical communication is being advanced.

From the invention thus described, it will be obvious that the invention may be varied in many ways. Such variations are not to be regarded as a departure from the scope of the invention, and all such modifications as would be obvious to one skilled in the art are intended to be included within the scope of the following claims.

## Claims

1. A semiconductor laser device comprising:
a housing (8) having an optical fiber (6) as a transmission path inserted therein;
a header (2) securing the housing integrally therewith;
a semiconductor laser chip (1A) mounted on the header (2) for emitting signal light to an incident end surface of the optical fiber (6) through a lens optical system (5; 9); and
a photodiode chip (1B) mounted on the header (2), and including a p-n junction as a light detecting region (13) for outputting a photocurrent generated by the signal light emitted from a backside of the semiconductor laser chip (1A), and a region (17) for capturing carriers generated by said signal light in a peripheral area of the p-n junction, the p-n junction and the region being formed on a light detecting surface.

2. A semiconductor laser device according to claim 1, wherein the charge capturing region (17) is formed by thermal diffusion of a metal element on an epitaxial layer (12) grown on a substrate (11), said charge capturing region (17) having the same polarity as the light detecting region (13).

3. A semiconductor laser device according to claim 1 or 2,
wherein the optical fiber (6) and the semiconductor laser chip (1A) are incontiguously optically coupled with each other through the lens optical system (5; 9), the incident end surface of the optical fiber (6) and the light emitting surface of the semiconductor laser being opposed to each other.

4. A semiconductor laser device according to any of claims 1 to 3,
wherein the semiconductor laser chip (1A) and the photodiode chip (1B) are incontiguously optically coupled with each other, and the backside of the light emitting surface of the semiconductor laser chip (1A) and the light detecting surface of the photodiode chip (1B) being opposed to each other.

5. A semiconductor laser device according to any of claims 1 to 4,
wherein the semiconductor laser chip (1A) and the photodiode chip (1B) both mounted on the header (2) are airtightly sealed with a cap (4; 19), and the interior of the cap is filed with an inert element.

6. A semiconductor laser device according to claim 5,
wherein the cap (4) has a light transmitting window (5) for passing the signal light emitted from the emitting surface of the semiconductor laser chip (1A).

7. A semiconductor laser device according to any of claims 1 to 6,
wherein the semiconductor laser chip (1A) is mounted on the header (2) through an Si submount (20).

8. A semiconductor laser device according to any of claims 1 to 7,
wherein the photodiode chip (1B) is mounted on the header (2) through a submount (21) of alumina ceramics.

9. A semiconductor laser device according to any of claims 1 to 8,
wherein the lens optical system is provided by a spherical lens (9; 5′).

10. A semiconductor laser device according to any of claims 7 to 9,
wherein the header (2) securing the semiconductor laser chip (1A) through the Si submount is provided by a metal package.

## Patentansprüche

1. Eine Halbleiter-Lasereinrichtung mit:
einem Gehäuse (8), das eine optische Faser (6) als ein darin eingesetzter Übertragungsweg aufweist;
einem Sockel (2), an dem das Gehäuse integral befestigt ist;
einem Halbleiter-Laserchip (1A), der auf dem Sockel (2) zum Ausstrahlen von Signallicht über ein optisches Linsensystem (5; 9) auf eine Einfallsstirnfläche der optischen Faser (6) befestigt ist; und
einem Photodiodenchip (1B), der auf dem Sockel (2) befestigt ist und einen PN-Übergang als einen Lichterfassungsbereich (13) zum Ausgeben eines Photostroms, der durch das von einer Rückseite des Halbleiter-Laserchips (1A) ausgestrahlte Signallichts erzeugt wird, und einen Bereich (17) zum Einfangen von durch das Signallicht in einer Umfangsfläche des PN-Übergangs erzeugten Ladungsträgern umfaßt, wobei der PN-Übergang und der Bereich auf einer lichterfassenden Oberfläche ausgebildet sind.

2. Eine Halbleiter-Lasereinrichtung nach Anspruch 1,
wobei der ladungseinfangende Bereich (17) durch thermische Diffusion eines Metallelements auf einer auf einem Substrat (11) aufgewachsenen Epitaxialschicht (12) ausgebildet ist, wobei der ladungseinfangende Bereich (17) die gleiche Polarität wie der lichterfassende Bereich (13) aufweist.

3. Eine Halbleiter-Lasereinrichtung nach Anspruch 1 oder 2,
wobei die optische Faser (6) und der Halbleiter-Laserchip (1A) über das optische Linsensystem (5; 9) miteinander ohne Berührung optisch gekoppelt sind, wobei die Einfallsstirnfläche der optischen Faser (6) und die lichtausstrahlende Fläche des Halbleiterlasers einander gegenüberliegen.

4. Eine Halbleiter-Lasereinrichtung nach irgendeinem der Ansprüche 1 bis 3,
wobei der Halbleiter-Laserchip (1A) und der Photodiodenchip (1B) miteinander ohne Berührung optisch gekoppelt sind und die Rückseite der lichtausstrahlenden Fläche des Halbleiter-Laserchips (1A) und die lichterfassende Fläche des Photodiodenchips (1B) einander gegenüberliegen.

5. Eine Halbleiter-Lasereinrichtung nach irgendeinem der Ansprüche 1 bis 4,
wobei der Halbleiter-Laserchip (1A) und der Photodiodenchip (1B), die beide auf dem Sockel (2) befestigt sind, mit einer Kappe (4; 19) luftdicht abgedichtet sind und das Innere der Kappe mit einem inerten Element ausgefüllt ist.

6. Eine Halbleiter-Lasereinrichtung nach Anspruch 5,
wobei die Kappe (4) ein lichtübertragendes Fenster (5) zum Hindurchlassen des Signallichtes aufweist, das von der ausstrahlenden Fläche des Halbleiter-Laserchips (1A) ausgestrahlt wird.

7. Eine Halbleiter-Lasereinrichtung nach irgendeinem der Ansprüche 1 bis 6,
wobei der Halbleiter-Laserchip (1A) auf dem Sockel (2) über eine Si-Montagebasis (20) befestigt ist.

8. Eine Halbleiter-Lasereinrichtung nach irgendeinem der Ansprüche 1 bis 7,
wobei der Photodiodenchip (1B) auf dem Sockel (2) über eine Montagebasis (21) aus Aluminiumoxid-Keramiken befestigt ist.

9. Eine Halbleiter-Lasereinrichtung nach irgendeinem der Ansprüche 1 bis 8,
wobei das optische Linsensystem durch eine sphärische Linse (5′) vorgesehen ist.

10. Eine Halbleiter-Lasereinrichtung nach irgendeinem der Ansprüche 7 bis 9,
wobei der Sockel (2), der den Halbleiter-Laserchip (1A) über die Si-Montagebasis sichert, durch ein Metallbauteil vorgesehen ist.

## Revendications

1. Dispositif laser à semi-conducteur comprenant :
une enceinte (8) dans laquelle est insérée une fibre optique (6) servant de trajet de transmission ;
un socle (2) qui fixe l'enceinte d'une manière solidaire ;
une pastille semi-conductrice à laser (1A) qui est montée sur le socle (2) pour émettre des signaux lumineux vers une surface terminale d'incidence de la fibre optique (6) à travers un système optique à lentille (5 ; 9) ; et :
une pastille formant photodiode (1B) qui est montée sur le socle (2) et qui comprend une jonction p-n, celle-ci servant de région de détection de la lumière (13) pour émettre un courant photoélectrique engendré par les signaux lumineux qui sont émis depuis un côté arrière de la pastille semi-conductrice à laser (1A), ainsi qu'une région (17) destinée à capturer des porteurs engendrés par lesdits signaux lumineux dans une zone périphérique de la jonction p-n, la jonction p-n et la région étant formées sur une surface de détection de la lumière.

2. Dispositif laser à semi-conducteur selon la revendication 1, dans lequel la région de capture des charges (17) est formée par diffusion thermique d'un élément métallique sur une couche épitaxiale (12) tirée sur un substrat (11), ladite région de capture des charges (17) présentant la même polarité que la région de détection de la lumière (13).

3. Dispositif laser à semi-conducteur selon la revendication 1 ou 2, dans lequel la fibre optique (6) et la pastille semi-conductrice à laser (1A) sans être contiguës, sont accouplées l'une à l'autre par voie optique à travers le système optique à lentille (5 ; 9), la surface terminale d'incidence de la fibre optique (6) et la surface d'émission de la lumière du laser à semi-conducteur étant opposées l'une à l'autre.

4. Dispositif laser à semi-conducteur selon l'une quelconque des revendications 1 à 3, dans lequel la pastille semi-conductrice à laser (1A) et la pastille formant photodiode (1B), sans être contiguës, sont accouplées l'une à l'autre par voie optique, le côté arrière de la surface d'émission de la lumière de la pastille semi-conductrice à laser (1A) et la surface de détection de la lumière de la pastille formant photodiode (1B) étant opposés l'un à l'autre.

5. Dispositif laser à semi-conducteur selon l'une quelconque des revendications 1 à 4, dans lequel la pastille semi-conductrice à laser (1A) et la pastille formant photodiode (1B) sont montées toutes les deux sur le socle (2) en étant enfermées d'une manière étanche à l'air par un capot (4 ; 19), l'intérieur du capot étant rempli d'un élément inerte.

6. Dispositif laser à semi-conducteur selon la revendication 5, dans lequel le capot (4) comporte une fenêtre de transmission de la lumière (5) pour faire passer les signaux lumineux qui sont émis par la surface émettrice de la pastille semi-conductrice à laser (1A).

7. Dispositif laser à semi-conducteur selon l'une quelconque des revendications 1 à 6, dans lequel la pastille semi-conductrice à laser (1A) est montée sur le socle (2) par l'intermédiaire d'un support de montage en silicium (20).

8. Dispositif laser à semi-conducteur selon l'une quelconque des revendications 1 à 7, dans lequel la pastille formant photodiode (1B) est montée sur le socle (2) par l'intermédiaire d'un support de montage en céramique d'alumine (21).

9. Dispositif laser à semi-conducteur selon l'une quelconque des revendications 1 à 8, dans lequel le système optique à lentille est constitué par une lentille sphérique (5′).

10. Dispositif laser à semi-conducteur selon l'une quelconque des revendications 7 à 9, dans lequel le socle (2) qui fixe la pastille semi-conductrice à laser (1A) par l'intermédiaire du support de montage en silicium est constitué par un bloc en métal.
